# EUROPÄISCHE PATENTANMELDUNG

(11) **EP 0 649 225 A1**
(43) Veröffentlichungstag der Anmeldung: **19.04.1995**
(21) Anmeldenummer: 94810602.6
(22) Anmeldetag: 14.10.1994
(51) Int. Cl.: H04B 1/04, H03F 3/217, H03F 1/52

(54) **Verfahren zur Ansteuerung einer Brückenschaltung sowie Anwendung des Verfahrens auf den Betrieb eines amplitudenmodulierten Rundfunksenders**

(30) Priorität: 15.10.1993 DE 4335227
(71) Anmelder: THOMCAST AG, CH-5300 Turgi (CH)
(72) Erfinder: Tomljenovic, Nenad, CH-5415 Nussbaumen (CH); Stucky, Andreas, CH-5430 Wettingen (CH)
(74) Vertreter: Hug Interlizenz AG

(57) **Zusammenfassung**

Es wird ein Verfahren zur Ansteuerung der Schalter (S1-S4) einer Brückenschaltung (1) angegeben, bei welchem Verfahren, falls keine Spannung an der Last (ZL) anliegen soll, die Schalter über der Last kurzgeschlossen werden. Dadurch erhält man in jedem Fall ein definiertes Potential über der Last, und die Quellenimpedanz, welche von der Last gesehen wird, ist im wesentlichen konstant. Mit dem erfindungsgemässen Verfahren angesteuerte Brückenschaltungen können deshalb auch für Anwendungen eingesetzt werden, welche eine definierte und konstante Quellenimpedanz fordern.

## Beschreibung

### Technisches Gebiet

Die Erfindung bezieht sich auf das Gebiet der Leistungselektronik. Sie betrifft ein Verfahren zur Ansteuerung einer Brückenschaltung nach dem Oberbegriff des Anspruchs 1.

Sie betrifft weiterhin eine Anwendung des Verfahrens zum Betrieb eines amplitudenmodulierten Rundfunksenders.

### Stand der Technik

Ein Verfahren der eingangs genannten Art wird beispielsweise im Lehrbuch "Leistungselektronik" von R. Lappe et al., Springer Verlag 1988, beschrieben.

Die Brückenschaltung umfasst zwei Halbbrücken mit je zwei in Serie geschalteten Schaltern. Die gemeinsamen Knotenpunkte der Schalter jeder Halbbrücke bilden die Lastanschlüsse. Die vier Schalter werden nun so angesteuert, dass immer zwei diagonal gegenüberliegende Schalter leiten, während die anderen geöffnet sind. Dadurch kann entweder der Plus- oder der Minuspol einer Gleichspannungsquelle, welche an die Brückenschaltung angeschlossen werden kann, auf die Last durchgeschaltet werden. Die Spannung an der Last ändert dadurch dauernd ihr Vorzeichen.

Solche Brückenschaltungen und Verfahren zur Ansteuerung derselben sind als Wechselrichter weit verbreitet.

Aus dem Artikel "Kilowatts on order" von R.S. Burden, IEEE Spektrum Februar 1993, sind nun weitere Anwendungen dieser Brückenschaltungen bekannt. Als Pulsdauermodulations-Verstärker werden sie für alle möglichen Zwecke wie Hochleistungsfunktionsgeneratoren, Breitband-Wechselstromquellen etc. eingesetzt. Zu diesem Zweck werden die Schalter der Brückenschaltung mit pulsdauermodulierten Signalen angesteuert. In den Pulspausen z.B. eines pulsdauermodulierten Ausgangssignals werden alle Schalter geöffnet, und der Laststrom z.B. einer induktiven Last kann über Freilaufdioden, welche parallel zu den Schaltern liegen, abfliessen.

Falls alle Schalter geöffnet sind, ist jedoch die Quellenimpedanz, welche die Last sieht, nicht definiert. Falls bei der Brückenschaltung keine Freilaufdioden vorgesehen sind, ist nicht einmal das Potential der Last definiert.

Gerade aber für Anwendungen, bei welchen der Brückenschaltung ein passives Filter, z.B. ein Tiefpass nachgeschaltet ist, wird eine jederzeit definierte Quellenimpedanz benötigt. Aber auch für eine induktive Last, an welche ein Signal mit einem definierten Rippel abgegeben werden soll, wäre eine definierte, möglichst kleine Quellenimpedanz vorteilhaft. Mit einer kleineren Quellenimpedanz würde nämlich die Zeitkonstante R/L (im wesentlichen R = Innenwiderstand der Quelle und L = Lastinduktivität) kleiner und somit die Flankensteilheit eines allfälligen Rippels geringer. Auf diese Weise könnte die Schaltfrequenz für einen geforderten, maximalen Rippelanteil wesentlich verkleinert werden.

Bei den Ansteuerverfahren nach dem Stand der Technik ist die Quellenimpedanz in dem Zustand, wo alle Schalter geöffnet sind, jedoch viel höher als in den beiden anderen Zuständen. Damit scheidet eine Brückenschaltung für Anwendungen, welche eine ungefähr konstante Quellenimpedanz fordern, von vornherein aus.

### Darstellung der Erfindung

Aufgabe der vorliegenden Erfindung ist es deshalb, ein Verfahren zur Ansteuerung einer Brückenschaltung anzugeben, bei welchem die Quellenimpedanz jederzeit definiert und im wesentlichen konstant ist, sowie eine Anwendung des Verfahrens anzugeben.

Diese Aufgabe wird bei einem Verfahren der eingangs genannten Art durch die Merkmale des Anspruchs 1 gelöst.

Kern der Erfindung ist es also, dass der Schaltzustand, bei welchem alle Schalter offen sind und keine Spannung am Ausgang liegt, durch Zustände ersetzt wird, bei welchen über der Last kurzgeschlossen wird.

Bei einem bevorzugten Ausführungsbeispiel sind parallel zu den Schaltern Freilaufdioden vorgesehen, und ein Kurzschluss über der Last kann auch dadurch erreicht werden, dass abhängig von der Stromrichtung jeweils nur ein Schalter geschlossen wird.

Der Vorteil des erfindungsgemässen Aufbaus besteht insbesondere darin, dass das Potential der Last und die von der Last gesehene Quellenimpedanz in jedem Zustand definiert ist. Deshalb kann eine erfindungsgemäss angesteuerte Brückenschaltung auch für Anwendungen eingesetzt werden, die eine konstante Quellenimpedanz fordern, z.B. für einen nachgeschaltetes, passives Filter. Zudem wird dadurch die rippelbestimmende Zeitkonstante kleiner, und für eine Ausgangsspannung mit einem definierten Rippelanteil genügt eine niedrigere Schaltfrequenz. Ebenso ist es möglich, die Ausgänge mehrerer Brückenschaltungen in Serie zu schalten und so eine höhere Ausgangsspannung zu erreichen.

Die Anwendung des Verfahrens nach der Erfindung auf den Betrieb eines amplitudenmodulierten Rundfunksenders, welcher eine Mehrzahl von gleichartigen, einzeln ein- und ausschaltbaren HF-Stufen umfasst, welche jeweils als Brückenschaltung ausgebildet sind und an ihren Ausgängen jeweils ein Wechselspannungssignal gleicher, der Trägerfrequenz entsprechender Frequenz, und überwiegend gleicher und konstanter Amplitude abgeben, wobei die Ausgangssignale der HF-Stufen aufsummiert und über ein Filter an eine Antenne abgegeben werden, und die Anzahl der eingeschalteten Stufen nach Massgabe eines NF-Eingangssignals verändert wird, zeichnet sich dadurch aus, dass zumindest ein Teil der HF-Stufen nach dem erfindungsgemässen Verfahren angesteuert wird.

Bei einer ersten bevorzugten Ausführungsform dieser Anwendung wird die Ansteuerung der HF-Stufen nach dem erfindungsgemässen Verfahren dazu verwendet, zur besseren Approximation des NF-Eingangssignals durch die Einhüllende der aus der Summation resultierenden Trägerschwingung die Amplitude der Ausgangssignale der betreffenden Stufen zu verändern.

Bei einer zweiten bevorzugten Ausführungsform dieser Anwendung werden alle HF-Stufen nach dem erfindungsgemässen Verfahren angesteuert, und alle HF-Stufen in einen der Zustände 31 bzw. 32 gesteuert, wenn vor und/oder hinter dem Filter eine die HF-Stufen gefährdende Störspannung auftritt.

Weitere Ausführungsformen ergeben sich aus den abhängigen Ansprüchen.

### Kurze Beschreibung der Zeichnungen

Nachfolgend wird die Erfindung anhand von Ausführungsbeispielen im Zusammenhang mit den Zeichnungen näher erläutert.

Es zeigen:
- **Fig. 1**: Ein Schaltbild einer Brückenschaltung;
- **Fig. 2**: Ein Schaltbild einer Brückenschaltung mit Freilaufdioden;
- **Fig. 3**: ein Blockschaltbild eines amplitudenmodulierten Rundfunksenders mit einzelnen HF-Stufen in Form von Brückenschaltungen, bei welchem Rundfunksender das erfindungsgemässe Verfahren Anwendung findet; und
- **Fig. 4**: Zeitdiagramme für die Steuerung der Schalter S1,..,S4 einer Brückenschaltung gemäss Fig. 1 bei einem herkömmlichen Rundfunksender gemäss der US-A-4,580,111 (Fig. 4a) und gemäss einem bevorzugten Ausführungsbeispiel für die Anwendung des erfindungsgemässen Verfahrens bei einem AM-Rundfunksender (Fig. 4b).

Die in den Zeichnungen verwendeten Bezugszeichen und deren Bedeutung sind in der Bezeichnungsliste zusammengefasst aufgelistet. Grundsätzlich sind in den Figuren gleiche Teile mit gleichen Bezugszeichen versehen.

### Wege zur Ausführung der Erfindung

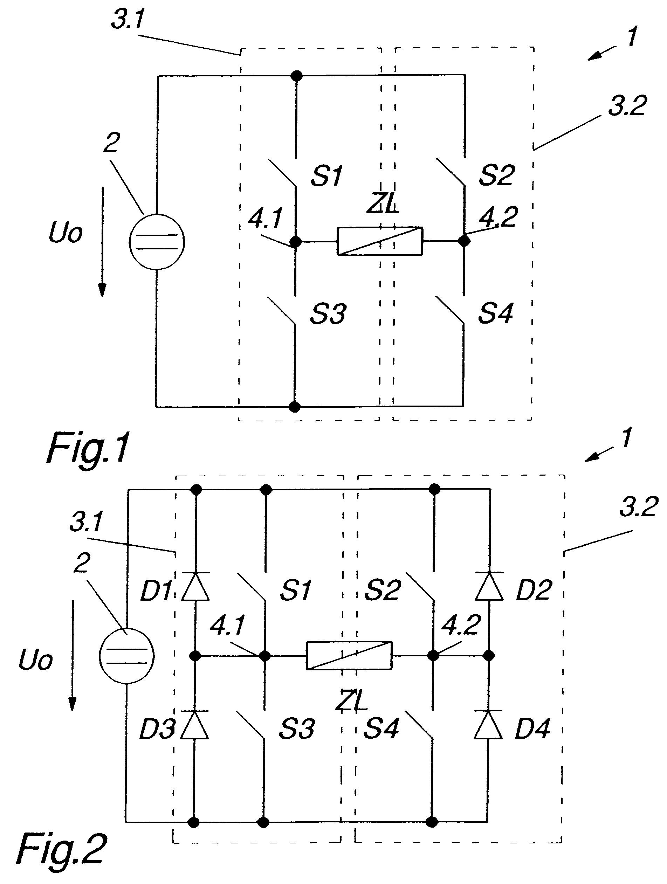

**Figur 1** zeigt das Schaltbild einer Brückenschaltung (1). Sie umfasst eine Gleichspannungsquelle (2), welche z.B. durch eine Gleichrichterschaltung mit Stützkondensator gebildet werden kann und eine Spannung Uo abgibt, sowie mindestens zwei Halbbrücken (3.1, 3.2), welche je parallel zur Gleichspannung geschaltet sind. Die Halbbrücken (3.1, 3.2) umfassen ihrerseits zwei in Reihe geschaltete Schalter (S1 und S3 bzw. S2 und S4). Der gemeinsame Knotenpunkt der Schalter bildet je einen Lastanschluss (4.1, 4.2). Die Schalter werden nun so durch eine nicht gezeichnete Ansteuereinheit angesteuert, dass über einer Last (ZL), welche an den Anschlüssen (4.1 und 4.2) angeschlossen werden kann, entweder die positive Gleichspannung Uo, die negative oder gar keine Spannung auftritt.

Für eine positive Lastspannung werden die Schalter S1 und S4 geschlossen, für eine negative die Schalter S2 und S3. Falls keine Spannung an der Last anliegen soll, werden nach dem Stand der Technik alle Schalter offen gelassen. Dies ergibt die folgenden 3 Schaltzustände:

| Zustand | S1 | S2 | S3 | S4 |
|---|---|---|---|---|
| 1 | zu | offen | offen | zu |
| 2 | offen | zu | zu | offen |
| 3 | offen | offen | offen | offen |

Im Zustand 3 ist die Spannung über der Last zwar Null, aber das Potential der Last ist nicht definiert, die Last "floatet". Gleichermassen ist die Quellenimpedanz, welche von der Last gesehen wird, theoretisch unendlich. Wie oben dargestellt wurde, ist dies jedoch sehr unerwünscht.

Nach der Erfindung kann der Zustand 3 nun dadurch umgangen werden, dass er durch folgende Zustände ersetzt wird:

| Zustand | S1 | S2 | S3 | S4 |
|---|---|---|---|---|
| 31 | zu | zu | offen | offen |
| 32 | offen | offen | zu | zu |

Damit wird die Last (ZL) in den Zuständen 31 und 32 über die Schalter S3 und S4 bzw. S1 und S2 kurzgeschlossen, Last-Potential und Quellenimpedanz sind definiert, und die Lastspannung ist wie gefordert Null.

Eine induktive Last speichert Energie, welche über den Kurzschluss abfliessen möchte. Falls die Schalter (S1-S4) rückwärtsleitend sind, geht das problemlos auch ohne spezielle Massnahmen. Falls sie jedoch nur in einer Richtung Strom führen können, müssen parallel zu den Schaltern Freilaufdioden (D1-D4) vorgesehen werden (**Figur 2**). Dadurch kann der Laststrom über eine Freilaufdiode und die geschlossenen Schalter abfliessen.

Falls der Laststrom vom ersten Lastanschluss (4.1) zum zweiten (4.2) fliesst, ist der Schalter S2 im Zustand 31 zur Stromführung nicht notwendig, so dass er auch offen gelassen werden kann. Ebenso verhält es sich für den Schalter S3 im Zustand 32. Fliesst der Strom hingegen umgekehrt, kann im Zustand 31 der Schalter S1 und im Zustand 32 der Schalter S4 offen gelassen werden.

Bei der Schaltung mit Freilaufdioden ist die Quellenimpedanz natürlich auch im Zustand 3 definiert. Mit der erfindungsgemässen Ansteuerung, d.h. den Zuständen 31 und 32 wird diese aber wesentlich verkleinert und ist somit über alle Zustände ungefähr konstant.

Mit dem erfindungsgemässen Ansteuerverfahren ist also das Potential einer Last einer Brückenschaltung in jedem Schaltzustand definiert. Deshalb kann eine Brückenschaltung, welche nach der Erfindung angesteuert wird, auch für Anwendungen eingesetzt werden, welche ein definiertes Lastpotential und damit eine definierte Quellenimpedanz fordern (z.B. nachgeschaltete Filter). Zudem wird die Quellenimpedanz ziemlich konstant auf einem kleinen Niveau gehalten. Dies bringt den grossen Vorteil mit sich, dass für eine geforderte Rippelhöhe mit kleinerer Schaltfrequenz gefahren werden kann, denn die dominierende Zeitkonstante R/L (im wesentlichen: R = Quellenimpedanz, L = Last-Induktivität) ist viel kleiner. Dadurch steigt der Rippel weniger steil an und ist insgesamt kleiner. Ein weitere Vorteil besteht darin, dass mehrere Brückenschaltungen in Serie geschaltet werden können.

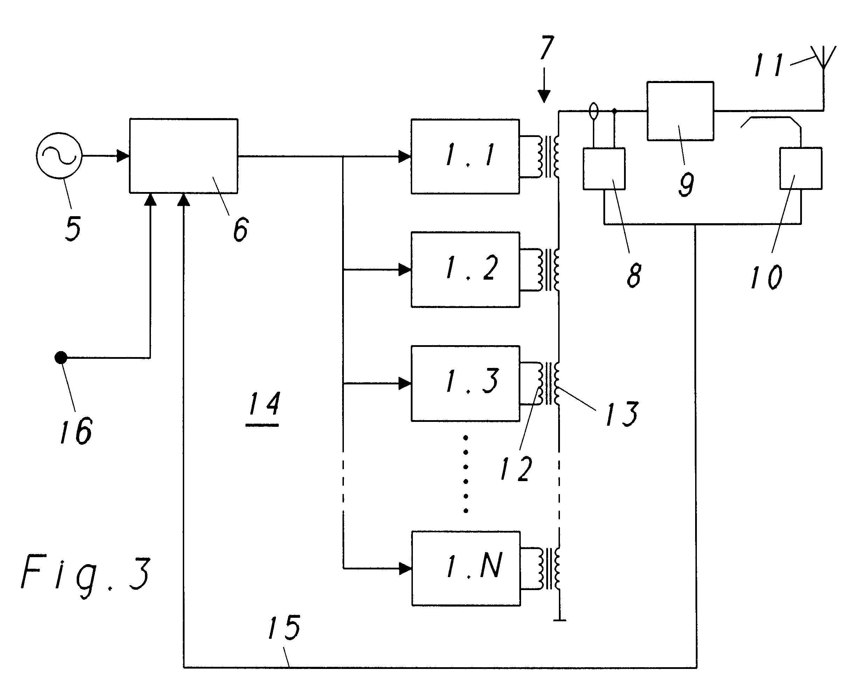

Mit besonderem Vorteil lässt sich gemäss der Erfindung das oben beschriebene Ansteuerverfahren beim Betrieb eines mit Brückenschaltungen aufgebauten amplitudenmodulierten Rundfunksenders 14 anwenden, wie er in Fig. 3 im Blockschaltbild dargestellt ist. Ein solcher Sender, dessen grundlegendes Prinzip z.B. in den Druckschriften US-A-4,580,111 (bzw. EP-B1-0 083 727) oder US-A-4,859,967 erläutert ist, umfasst eine Mehrzahl von HF-Stufen 1.1,..,1.N, die jeweils intern als Brückenschaltungen der in Fig. 2 gezeigten Art aufgebaut sind. Als Schalter S1,..,S4 kommen dabei vorzugsweise Leistungs-MOSFETs zur Anwendung.

Die HF-Stufen bzw. Brückenschaltungen 1.1,..,1.N werden über eine Steuerung 6 von einer Trägerfrequenzquelle 5 angesteuert, wobei die Schalter S1,..,S4 der einzelnen Stufen so geschaltet werden, dass sich am Ausgang der Stufe ein Rechtecksignal ergibt, dessen Grundfrequenz der Trägerfrequenz entspricht. Die HF-Stufen 1.1,..,1.N sind mit ihren Ausgängen an eine Summationseinrichtung 7 angeschlossen, die eine entsprechende Anzahl von Primärwicklungen 12 und eine oder mehrere Sekundärwicklungen 13 aufweist. Die Primärwicklung 12 entspricht dabei jeweils der Lastimpedanz ZL aus Fig. 1 bzw. Fig. 2.

Die in der Summationseinrichtung 7 aufsummierten Ausgangssignale aus den HF-Stufen 1.1,..,1.N, die zunächst näherungsweise Rechtecksignale sind, werden in einem nachfolgenden Filter 9, welches beispielsweise als Bandpass ausgebildet ist, von den Oberwellen befreit und auf eine Antenne 11 gegeben und abgestrahlt. Die Amplitudenmodulation wird dadurch erreicht, dass gemäss dem an einem NF-Eingang 16 anliegenden NF-Eingangssignal von der Steuerung 6 nur so viele HF-Stufen angesteuert werden, wie dem Augenblickswert der NF-Amplitude entsprechen. Einzelheiten der Ansteuerung können den o.g. Druckschriften entnommen werden.

Bei einem solchen (digital arbeitenden) AM-Rundfunksender treten verschiedene Probleme auf: Zum einen wird bei der Verwendung von gleichartigen HF-Stufen das an sich stetig variierende NF-Signal im Verstärker/Modulator durch ein treppenstufenförmiges Signal approximiert. Die Qualität der Approximation hängt dabei von der Anzahl der Stufen ab, so dass für eine gute Approximation ein hoher Schaltungsaufwand betrieben werden müsste. Zum anderen können Störspannungen, die am Senderausgang durch Fehlanpassung an die Antenne oder Blitzeinschlag hervorgerufen werden, über den Filter 9 und die Summationseinrichtung 7 auf die einzelnen HF-Stufen 1.1,..,1.N und deren MOSFET-Schalter zurückwirken und zu Zerstörungen führen.

Zum ersten Problem ist in der bereits genannten US-A-4,580,111 als Lösung vorgeschlagen worden, neben den gleichartigen HF-Stufen weitere Stufen einzusetzen, die nur ein Bruchteil der Ausgangsamplitude der anderen Stufen abgeben und vorzugsweise binär abgestuft sind. Dies hat jedoch den Nachteil, dass im Sender hinsichtlich des Leistungsbereichs verschiedene Arten von HF-Stufen eingesetzt werden müssen, was zu erhöhten Anlagenkosten führt. Günstiger ist es daher, alle HF-Stufen gleich auszubilden und Zwischenwerte in der Approximation durch eine spezielle Ansteuerung einzelner Brückenschaltungen bzw. von deren Schaltern S1,..,S4 zu erreichen.

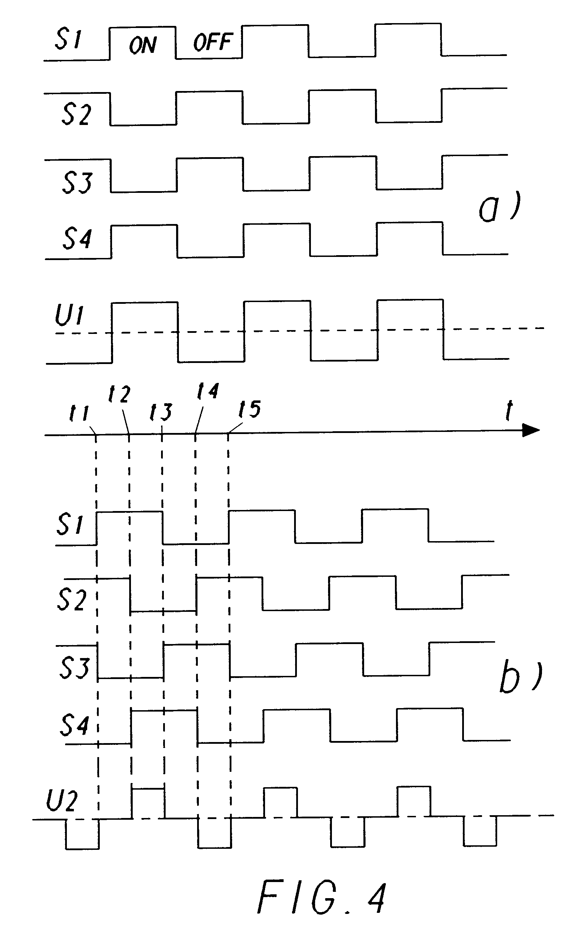

Dieses Prinzip kann anhand der Fig. 4 näher erläutert werden: In Fig. 4a sind die Zeitdiagramme der bekannten Art der Brükkenansteuerung in einem AM-Rundfunksender der beschriebenen Art wiedergegeben. Die beiden Halbbrücken (3.1 und 3.2 in Fig. 1) mit ihren Schaltern S1, S3 bzw. S2, S4 werden synchron geschaltet, wobei jeweils die Schalter S1 und S4 eingeschaltet (ON) und die Schalter S2 und S3 ausgeschaltet (OFF) sind, und umgekehrt. Am Brückenausgang liegt stets eine Gleichspannung, die im Rhythmus der Schaltvorgänge ihr Vorzeichen wechselt, so dass eine rechteckförmige Ausgangswechselspannung U1 resultiert. Die HF-Stufen haben dabei entweder alle dieselbe Phase und dieselbe Amplitude oder - wenn die Feinapproximation gemäss der US-A-4,580,111 verwendet wird - teilweise eine binär abgestufte Amplitude.

Zwischenwerte lassen sich bei unveränderter HF-Stufe nun mit sehr viel weniger Aufwand dadurch erreichen, dass in wenigstens einer Stufe bei gleichbleibender Maximalamplitude, d.h. bei gleicher Gleichspannung Uo, die von der Brückenschaltung am Ausgang abgegebenen positiven und negativen Halbwellen in ihrer Pulsdauer verändert werden. Je kürzer die Pulsdauer ist, desto kleiner ist dann die Amplitude der am Senderausgang durch den zeitlichen Integrationseffekt des Filters anstehende Amplitude der Grundschwingung, so dass durch eine stetige Veränderung der Pulsdauer die Zwischenwerte zwischen zwei Approximationsstufen stetig eingestellt werden können.

Die Pulsdauer lässt sich gemäss Fig. 4b einfach dadurch einstellen, dass die Halbbrücken 3.1 und 3.2 nicht mehr synchron, sondern gegeneinander phasenverschoben angesteuert werden, d.h., die Schalter S1 und S3 der ersten Halbbrücke 3.1 werden zu Zeitpunkten t1, t3, t5,... geschaltet, die von den Schalt-Zeitpunkten t2, t4,... der Schalter S2 und S4 der zweiten Halbbrücke 3.2 verschieden sind. Es ergibt sich dann eine Ausgangswechselspannung U2, die aus positiven und negativen Rechteckimpulsen besteht, die zwar dieselbe Amplitude besitzen wie die Spannung U1 in Fig. 4a, jedoch eine nach Massgabe der Phasenverschiebeung zwischen den Halbbrücken veränderbare Pulsdauer aufweisen.

Man erkennt in diesem Zusammenhang sofort, dass bei dieser Art der Schaltersteuerung in den Zeitintervallen (t1-t2, t3-t4,...), in denen die Spannung am Brückenausgang (U2) null ist, entweder die oberen Schalter S1, S2 oder die unteren Schalter S3, S4, eingeschaltet sind, so dass bei dieser Art der Brückenansteuerung das Verfahren nach der Erfindung Anwendung findet. Der damit verbundene Kurzschluss der Primärwicklungen 12 der Summationseinrichtung 7 sorgt dafür, dass das Filter 9 in jedem Fall eine endliche Quellenimpedanz sieht, ohne die eine ordnungsgemässe Funktion des Filters nicht möglich ist.

Zum zweiten Problem ist in der o.g. US-A-4,859,967 vorgeschlagen worden, die Störspannungen am Ausgang zu detektieren und beim Auftreten einer solchen Störspannung die HF-Stufen abzuschalten und gleichzeitig eine zur Störspannung gleichphasige Gegenspannung über die Treiberstufe an die MOSFETs in den Brückenschaltungen zu legen, um zerstörerische Potentialunterschiede an den MOSFETs zu verhindern. Hierzu wird eine Zusatzelektronik benötigt, die aufwendig ist und hinsichtlich der Phasenverhältnisse sehr präzise ausgelegt sein muss.

Wesentlich einfacher und weniger kritisch lässt sich dagegen der Einfluss von Störspannungen am Senderausgang auf die HF-Stufen 1.1,..,1.N begrenzen, wenn gemäss einer weiteren Anwendung des erfindungsgemässen Verfahrens alle HF-Stufen 1.1,..,1.N in einen der Zustände 31 bzw. 32 gesteuert werden, wenn vor und/oder hinter dem Filter 9 eine die HF-Stufen 1.1,..,1.N gefährdende Störspannung auftritt. Hierdurch werden die Primärwicklungen 12 der Summationseinrichtung kurzgeschlossen, so dass keine für die Brückenschaltungen 1 gefährlichen Spannungen in ihnen induziert werden können.

Zur Detektierung einer die HF-Stufen 1.1,..,1.N gefährdenden Störspannung werden vorzugsweise vor dem Filter 9 mittels einer Phasenmesseinrichtung 8 (Fig. 3) die Phase zwischen dem Strom und der Spannung und/oder hinter dem Filter 9 mittels einer Reflexionsmesseinrichtung 10 der Antennen-Reflexionsfaktor gemessen. Tritt ein Störzustand auf, wird über eine Steuerleitung 15 ein entsprechendes Signal an die Steuerung 6 gegeben, die dann sofort die HF-Stufen 1.1,..,1.N in den Kurzschluss steuert, d.h. die Schalter S1 und S2 und/oder S3 und S4 in jeder Brückenschaltung 1 schliesst.

### Bezeichnungsliste

- 1: Brückenschaltung
- 1.1,..,1.N: HF-Stufe
- 2: Gleichspannungsquelle
- 3.1, 3.2: Halbbrücken
- 4.1, 4.2: Lastanschlüsse
- 5: Trägerfrequenzquelle
- 6: Steuerung
- 7: Summationseinrichtung
- 8: Phasenmesseinrichtung
- 9: Filter (Bandpass)
- 10: Reflexionsmesseinrichtung
- 11: Antenne
- 12: Primärwicklung
- 13: Sekundärwicklung
- 14: Rundfunksender
- 15: Steuerleitung
- 16: NF-Eingang
- S1-S4: Schalter
- ZL: Lastimpedanz
- D1-D4: Freilaufdioden
- Uo: Gleichspannung
- U1,U2: Ausgangsspannung
- t1,..,t5: Zeitpunkt

## Patentansprüche

1. Verfahren zur Ansteuerung einer Brückenschaltung (1), welche mindestens zwei Halbbrücken (3.1, 3.2) mit je zwei Schaltern S1 und S3 bzw. S2 und S4 umfasst, wobei die gemeinsamen Knotenpunkte der Schalter (S1, S3 bzw. S2, S4) je einen Lastanschluss (4.1, 4.2) bilden, an welchen eine Last (ZL) angeschlossen werden kann, bei welchem Verfahren die Schalter(S1-S4) gemäss einem der folgenden zwei Schaltzustände wiederholt angesteuert werden:
| Zustand | S1 | S2 | S3 | S4 |
|---|---|---|---|---|
| 1 | zu | offen | offen | zu |
| 2 | offen | zu | zu | offen |
dadurch gekennzeichnet, dass die Schalter (S1-S4) in einem weiteren Zustand, bei welchem keine Spannung an die Last (ZL) abgegeben wird, so angesteuert werden, dass einer der Schaltzustände der folgenden Tabelle resultiert:
| Zustand | S1 | S2 | S3 | S4 |
|---|---|---|---|---|
| 31 | zu | zu | offen | offen |
| 32 | offen | offen | zu | zu |

2. Verfahren nach Anspruch 1, dadurch gekennzeichnet, dass
a) parallel zu den Schaltern (S1-S4) Freilaufdioden (D1-D4) vorgesehen sind,
b) der Schalter (S2) im Zustand 31 und der Schalter (S3) im Zustand 32 offen gelassen werden kann, falls ein Strom durch die Last (ZL), vom Lastanschluss (4.1) zum Lastanschluss (4.2) fliesst,
c) der Schalter (S1) im Zustand 31 und der Schalter (S4) im Zustand 32 offen gelassen werden kann, falls ein Strom durch die Last (ZL) vom Lastanschluss (4.2) zum Lastanschluss (4.1) fliesst.

3. Anwendung des Verfahrens nach Anspruch 1 auf den Betrieb eines amplitudenmodulierten Rundfunksenders (14), welcher eine Mehrzahl von gleichartigen, einzeln ein- und ausschaltbaren HF-Stufen (1.1,..,1.N) umfasst, welche jeweils als Brückenschaltung (1) ausgebildet sind und an ihren Ausgängen jeweils ein Wechselspannungssignal gleicher, der Trägerfrequenz entsprechender Frequenz, und überwiegend gleicher und konstanter Amplitude abgeben, wobei die Ausgangssignale der HF-Stufen (1.1,..,1.N) aufsummiert und über ein Filter (9) an eine Antenne (11) abgegeben werden, und die Anzahl der eingeschalteten Stufen nach Massgabe eines NF-Eingangssignals verändert wird, dadurch gekennzeichnet, dass zumindest ein Teil der HF-Stufen (1.1,..,1.N) nach dem Verfahren gemäss Anspruch 1 angesteuert wird.

4. Anwendung nach Anspruch 3, dadurch gekennzeichnet, dass zur besseren Approximation des NF-Eingangssignals durch die Einhüllende der aus der Summation resultierenden Trägerschwingung dass die Halbbrücken (3.1, 3.2 ) des zumindest einen Teils der HF-Stufen (1.1,..,1.N) gegeneinander phasenverschoben angesteuert werden, und dass in den Zeitintervallen (t1-t2, t3-t4,...), in denen die Ausgangsspannung (U2) des zumindest einen Teils der HF-Stufen (1.1,..,1.N) null ist, entweder die oberen Schalter S1, S2 oder die unteren Schalter S3, S4, eingeschaltet sind.

5. Anwendung nach Anspruch 3, dadurch gekennzeichnet, dass alle HF-Stufen (1.1,..,1.N) nach dem Verfahren gemäss Anspruch 1 angesteuert werden, und dass alle HF-Stufen (1.1,..,1.N) in einen der Zustände 31 bzw. 32 gesteuert werden, wenn vor und/oder hinter dem Filter (9) eine die HF-Stufen (1.1,..,1.N) gefährdende Störspannung auftritt.

6. Anwendung nach Anspruch 5, dadurch gekennzeichnet, dass zur Detektierung einer die HF-Stufen (1.1,..,1.N) gefährdenden Störspannung vor dem Filter (9) die Phase zwischen dem Strom und der Spannung und/oder hinter dem Filter (9) der Antennen-Reflexionsfaktor gemessen werden.
